Europäisches Patentamt

European Patent Office

Office européen des brevets

(11) Publication number: **0 205 140**
A2

# EUROPEAN PATENT APPLICATION

(21) Application number: 86107824.4

(22) Date of filing: 09.06.86

(51) Int. Cl.4: **H 03 K 4/50**

(30) Priority: 10.06.85 US 743225

(43) Date of publication of application:
17.12.86 Bulletin 86/51

(84) Designated Contracting States:
AT BE CH DE FR GB IT LI LU NL SE

(71) Applicant: SPACELABS, INC.
4200 150th Avenue NE
Redmond Washington 98073-9713(US)

(72) Inventor: Lee, Michael G.
16117 N.E. 95th Court
Redmond Washington(US)

(74) Representative: VOSSIUS & PARTNER
Siebertstrasse 4 P.O. Box 86 07 67
D-8000 München 86(DE)

(54) Dynamically variable linear circuit.

(57) A constant current source is coupled to first sides of a parallel arrangement of binary weighted capacitors. The remaining sides of the capacitors are coupled in parallel to a digital register circuit such as a flip flop. The rate of change of the voltage output signal from the circuit is linear and the slope is determined by the selection of capacitors made in response to the data stored in the register. Similarly, a circuit is constructed in which a time delay or RC time constant is generated which is linearly related to the binary value of the data stored in the register by replacing the constant current source with a resistance circuit.

FIG. I

# VOSSIUS & PARTNER

PATENTANWÄLTE
EUROPEAN PATENT ATTORNEYS

SIEBERTSTRASSE 4 · 8000 MÜNCHEN 86 · PHONE: (089) 47 40 75
TELEX 529 453 VOPAT D          TELEFAX (089) 47 20 01 (GR. II + III)

**0205140**

Our Ref.: U 629 EP                                    June 9, 1986
Case: V-743,225-Z                  - 1 -
Spacelabs, Inc.
Redmond, USA

## DYNAMICALLY VARIABLE LINEAR CIRCUIT

The present invention relates to an electronic circuit useful for providing ramp outputs and time delays, more particularly, for providing linear ramp output signals and variable time delays which are linearly related to an input parameter.

There are many applications wherein it is desireable to provide a circuit to produce a linear ramp output signal whose slope is easily and precisely changed in response to a digital input signal. Similarly, it is desireable to provide a time delay circuit whose time delay is linearly related to a digital input signal.

One application is in the area of waveform display on a raster scan cathode ray tube (CRT) display device where it is desireable to provide smoothing for a digitally sampled waveform. In such an application it has been found effective to linearly increase and decrease the width of the electron beam along each raster scan line in response to the amplitude of the sampled waveforms.

In accordance with the present invention a circuit is provided which is capable of generating a linear ramp output signal whose slope is dependent on a plurality of adjustable control signals. In the preferred embodiment the circuit includes a current source and a plurality of capacitors which are coupled together in parallel to the current source. A multibit digital register provides the control signals in parallel to the capacitors on sides of the capacitors opposite the coupling to the current source. The capacitors are arranged to provide a binary sequence of capacitive values starting with $C_o$ at a first end and increasing by a factor of 2 from one capacitor to the next to the opposite end of the plurality of parallel capacitors. The capacitance of the circuit is dependent upon which capacitors are selected by the control signals. Since the current is constant this determines the slope.

In an alternate embodiment a circuit is provided for providing time delays which are linearly proportional to a plurality of multibit digital control signals. In place of the current source, the parallel capacitors are coupled in parallel through a resistor to a voltage source. The capacitance of the circuit is determined by the capacitors selected and this in combination with the resistance determines the RC time constant of the circuit.

FIG. 1 is a block diagram schematic of a linear ramp generator circuit of the present invention.

FIG. 2. is a curve showing two voltage outputs of the circuit of FIG. 1.

FIG. 3. Is a more detailed schematic of the circuit of FIG. 1.

FIG. 4. is a block diagram schematic of a time delay circuit of the present invention.

FIG. 5. is a more detailed schematic of the circuit of FIG. 4.

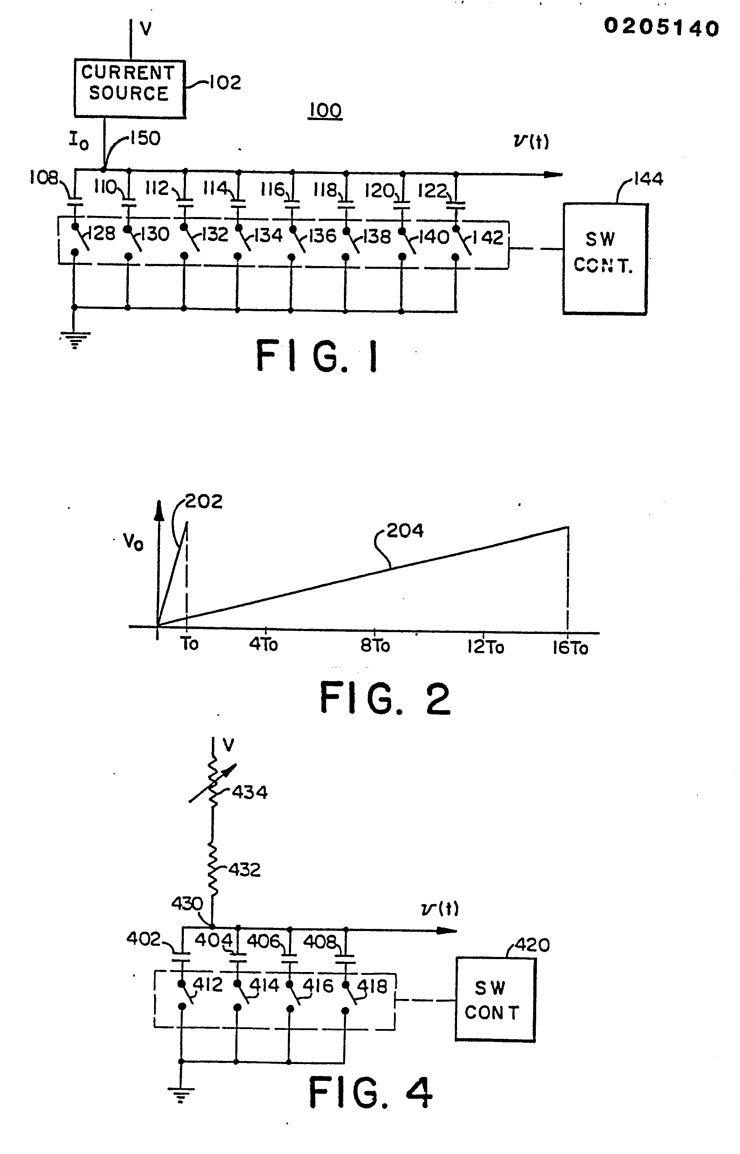

Referring now to FIG. 1, a schematic diagram of the present invention ramp generator circuit designated generally 100 is shown. The circuit comprises a constant current source 102 having an output $I_o$. The circuit further comprises a plurality of capacitors even numbers 108 through 122 coupled together on first sides thereof to the constant current source 102. Each of the capacitors 108 through 122 are coupled through switches even numbers 128 through 142, respectively, to ground. The switches are shown diagrammatically as being electronically and remotely controlled by a switch controller 144, each switch being capable of individual control.

The capacitors in the preferred embodiment of the invention have values which are related to one another in a binary relationship. In particular, if the smallest value capacitor 108 has a value of $C_o$, the next smallest value capacitor, capacitor 110, has a value of $2C_o$. Given a series of eight capacitors as shown in FIG. 1, their values range from $C_o$ to $128C_o$.

The slope of the voltage output signal, dv(t)/dt, measured at the coupling between the capacitors 108 through 122 and the constant current source 102 at node 150 is given by

$$\frac{dv}{dt} = \frac{I_o}{C}$$

The current $I_o$ is a constant and for a particular value of C the slope of dv/dt will vary linearly. If C is changed then the slope changes.

By choosing selectively various ones of the switches 128 through 142, the value of C can be changed. Since the capacitors are coupled in parallel, C will equal the total capacitance of all capacitors 108 through 122 which are coupled to ground by the selected switches. For example, referring also to FIG. 2, if only switch 128 is closed, the slope of v(t) is as shown by curve 202. If switches 128, 130, 132 and 134 are closed, the result will be curve 204. The greater the capacitance the smaller the slope, or the greater the rise time of v(t) from one voltage level to another.

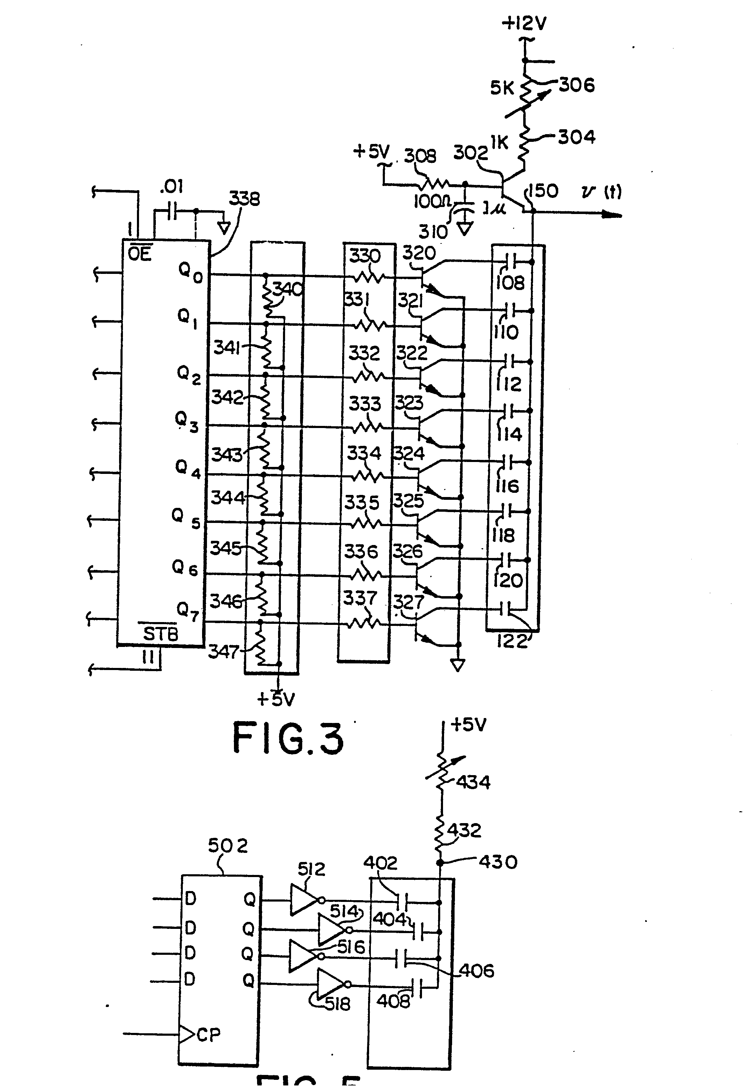

FIG. 3 is a more detailed schematic of an implementation of the block diagram of FIG 1. It is a circuit used to generate the increasing ramp of the trapezoidal beam pattern of the apparatus described in my above mentioned co-pending patent application. The constant current source comprises a transistor 302 whose emitter is coupled through 1000 ohm resistor 304 and 5000 ohm variable resistor 306 in series to a plus 12 volt source. The transistor base is coupled through 100 ohm resistor 308 to a plus 5 volt source and through a 0.1 microfarad capacitor to ground. The transistor collector is coupled to node 150. The sides opposite the first sides of capacitors 108 through 122 are coupled in parallel to the collectors of transistors 320 through 327, respectively where the emitters are all coupled to-gether and grounded. The bases of transistors 320 through 327 are coupled to first ends of resistors 330 through 337, respectively, whose other ends are coupled to the Q outputs of a 74HC374 eight bit register 338 and through resistors 340 through 347, respectively, to plus 5 volts.

In response to digital signals provided as input signals to register 338, certain ones of the capacitors 320 through 327 are selected. When a logic level high is present at the base of one of the transistors 320 through 327 the associated capacitor is added to the circuit and its value is added to the capacitance which determines the slope of the output voltage, v(t).

The capacitor network shown in FIG. 3 comprising capacitors even numbers 108 through 122 is available as a custom SIP consisting of 8 binary weighted capacitors with a single common lead. With $C_o$ = 25 picofarads (pf) the circuit provides a capacitance from 40 to 6400 pf with 25 pf steps. With the constant current source design chosen here in FIG. 3 this leads to ramp times from 0 to +5 volts in the range of approximately 35 to 5120 ns. Of course other ramps can be designed using different current values and capacitor networks. Decreasing ramps can also be designed.

Referring now to FIG. 4, a time delay circuit similar to that shown in FIG. 1 is shown comprising parallel capacitors even numbers 402 through 408 coupled on one side through switches even number 412 through 418, respectively to ground. The switches are remotely and individually controllable by swtich controller 420. The opposite sides of the capacitors from those coupled to the switches are connected together at node 430. Instead of a constant current source as in FIG. 1, resistor 432 and variable resistor 434 are coupled in series between node 430 and a voltage source. Those capacitors which are coupled to ground by closing the associated switches add to the capacitance of the circuit. In this way the RC time constant of the circuit is remotely and electronically variable.

In the preferred embodiment, the capacitors are arranged such that their capacitive values are in a binary sequence. For example, if capacitor 402 has a value $C_o$ , then capacitor 404 is $2C_o$, 406 is $4C_o$ and 408 is $8C_o$. The time delay output of the circuit will have a linear relationship to the digital input signal applied to the switches.

FIG. 5 is a more detailed implementation of the block diagram of FIG. 4. It comprises a 74HC175 quad D flip flop circuit 502 where Q outputs are coupled through open collector inverters (74LS05 devices) even numbers 512 through 518 to capacitors 402 through 408, respectively. The opposite sides of the capacitors are, as described earlier, coupled together at node 430 at which node series resistors 432 and 434 are also coupled. Resistor 432 has a value of 470 ohm while resistor 434 is a 100 ohm variable resistor.

Custom binary weighted capacitor network chips are available. With $C_o=25pf$, and the

resistors 432 and 434 as shown, 16 different delays are possible with 4 nanosecond resolutions.

Using the teachings of the present invertion analog ramp signals can be generated from digital control signals whose slopes are linearly proportional to the binary value of the digital signal. Similarly, a circuit is provided which generates time delays for analog applications which are linearly related to the binary value of digital control signals.

-8-

<u>CLAIMS</u>

1. A circuit for generating linear ramp voltage output signals comprising:

an input circuit for providing adjustable control signals;

a constant current source; and

means coupled to said constant current source for generating said linear ramp voltage output signals, the slope of which is responsive to said adjustable control signals.

2. The circuit of Claim 1 wherein said generating means comprises:

a plurality of capacitors coupled together in parallel to said constant current source.

3. The circuit of Claim 2 wherein said input circuit comprises:

a multibit digital register whose output terminals are coupled in parallel to said capacitors on opposite sides of said capacitors to said coupling to said current source.

4. The circuit of Claim 3 wherein said register is a multibit flip flop circuit.

5. The circuit of any of Claims 2 to 4, wherein starting with a preselected capacitance value $C_o$ at a first end of said plurality of parallel capacitors the capacitive value of adjacent capacitors increases by a factor of two from said first end to said remaining end.

6. The circuit of any of Claims 2 to 5 wherein said constant current source comprises:

a transistor whose base is coupled to a voltage source.

7. A time delay circuit comprising:

an input circuit for providing a plurality of digital control signals, and

means for generating a time delay signal which is linearly proportional to said digital control signals.

8. The circuit of Claim 7 wherein said generating means comprises:

a plurality of capacitors coupled together in parallel through a resistor circuit to a voltage source.

9. The circuit of Claim 8 wherein said input circuit comprises:

a multibit digital register whose output terminals are coupled in parallel to said capacitors on opposite sides of said capacitors to said coupling to said resistor circuit.

10. The circuit of Claim 9 wherein said register is a multibit flip flop circuit.

11. The circuit of any of Claims 8 to 10 wherein starting with a preselected capacitance value Co at a first end of said plurality of parallel capacitors the capacitance value of adjacent capacitors increases by a factor of two from said first end to said remaining end.

12.  A method of generating analog voltage ramp signals in response to digital control signals comprising the steps of:

selecting certain ones of an array of parallel capacitors in response to said constant signals; and

coupling a constant current from a constant current source to said array of capacitors.

13.  The method of claim 12 wherein said parallel capacitors have binary weighted capacitance values.

14.  A method of generating time delays in response to digital control signals comprising the steps of:

selecting certain ones of an array of parallel capacitors in response to said control signals; and

coupling a resistance circuit to said array of parallel capacitors to form an RC response time.

15.  The method of claim 14 wherein said parallel capacitors have binary weighted capacitance values.

FIG. 1

FIG. 2

FIG. 4

FIG.3

FIG.5